# EUROPEAN PATENT APPLICATION

(11) **EP 1 164 628 A2**
(43) Date of publication of application: **19.12.2001**
(21) Application number: 01112910.3
(22) Date of filing: 05.06.2001
(51) Int. Cl.: H01J 37/32

(54) **Processing system and method**

(30) Priority: 13.06.2000 US 593729
(71) Applicant: Applied Materials, Inc., Santa Clara, California 95054 (US)
(72) Inventor: Raoux, Sebastien, Cupertino, CA 95014 (US); Tanaka, Tsutomu (Tom), Santa Clara, CA 95051 (US); Nowak, Thomas, Cupertino, CA 95014 (US)
(74) Representative: Kirschner, Klaus Dieter, Dipl.-Phys.

(57) **Abstract**

A processing system is provided that includes a processing chamber, and a source of gas coupled to the processing chamber for supplying a gas thereto. A pump is located adjacent the processing chamber, and is coupled to the processing chamber for pumping the gas from the processing chamber. The processing system further includes a recycling line, coupled to the pump and adapted to cycle at least a portion of the gas pumped from the processing chamber back into the processing chamber. Methods for cleaning deposition chambers and for etching semiconductor substrates are also provided.

## Description

The present invention relates generally to semiconductor processing, and more specifically to methods and apparatus for increasing the utilization efficiency of gases during semiconductor processing.

The manufacture of liquid crystal displays, flat panel displays, thin film transistors and other semiconductor devices occurs within a plurality of chambers, each of which is designed to perform a specific process on the substrate. Many of these processes can result in an accumulation of material (e.g., material deposited on the substrate in layers, such as by chemical vapor deposition, physical vapor deposition, thermal evaporation, material etched from substrate surfaces, and the like) on chamber surfaces. Such accumulated material can crumble from the chamber surfaces and contaminate the sensitive devices being processed therein. Accordingly, process chambers must be cleaned of accumulated materials frequently (e.g., every 1-6 substrates).

To clean chamber surfaces, an in-situ dry cleaning process is typically employed. In an in-situ dry cleaning process one or more gases are dissociated to form one or more reactive gas species (e.g., fluorine ions, radicals). The reactive species clean chamber surfaces by forming volatile compounds with the material accumulated on those surfaces. Unfortunately, as described further below, such chamber cleaning processes conventionally consume considerable amounts of cleaning gases as well as consuming considerable amounts of energy, and thus undesirably increase the cost per substrate processed within a processing chamber. Similar gas and energy consumption problems also occurs during processes which employ reactive gas species to etch material from substrate surfaces. Accordingly, there is a need for an improved method and apparatus for etching accumulated material from chamber surfaces and/or for etching deposited material from substrate surfaces.

In accordance with at least one embodiment of the present invention, a novel processing system is provided. The novel processing system includes a processing chamber and a source of gas coupled to the processing chamber for supplying a gas thereto. A pump is located adjacent the processing chamber, and is coupled to the processing chamber for pumping the gas from the processing chamber. The processing system further includes a recycling line, coupled to the pump and adapted to cycle at least a portion of the gas pumped from the processing chamber back into the processing chamber. Improved methods for cleaning deposition chambers and for etching semiconductor substrates are also provided.

As described further below, energy consumption maybe reduced by positioning the pump adjacent the processing chamber. Further, the inventive methods and apparatus described herein may reduce gas consumption, reduce power requirements, reduce hazardous air pollutant (HAP) emissions and reduce global warming gas/PFC emissions during cleaning and/or etching processes. Accordingly, the present invention may reduce the overall cost (e.g., economic and environmental) of semiconductor device manufacturing.

Other features and advantages of the present invention will become more fully apparent from the following detailed description of the preferred embodiments, the appended claims and the accompanying drawing.
FIG. 1 is a diagrammatic side view of an inventive processing system; and
FIG. 2 is a diagrammatic side view of an inventive processing system that represents an exemplary embodiment for the inventive processing system of FIG. 1.

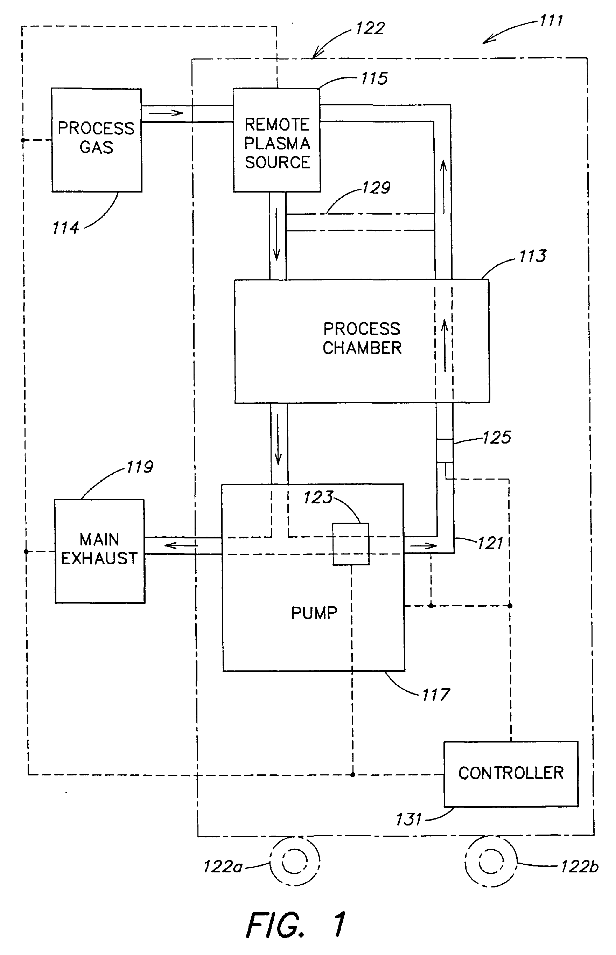

FIG. 1 is a diagrammatic side view of an inventive processing system 111. With reference to FIG. 1, the inventive processing system 111 comprises a processing chamber 113 coupled to a source of process gas 114 (e.g., a source of NF₃) via a remote plasma source 115, and coupled to a pump 117 (e.g., a mechanical pump, a turbo-molecular pump, etc.). The pump 117 is coupled to a main exhaust 119 (e.g. an exhaust used by a plurality of processing chambers such as the main exhaust of a clean room), and a recycling line 121 is coupled between the pump 117 and the remote plasma source 115.

In accordance with the invention, and unlike conventional processing system configurations, the pump 117 is positioned adjacent the processing chamber 113 to reduce recombination of at least one reactive species (e.g., F) when the reactive species travels from the processing chamber 113 to the pump 117 (as described below). Preferably the pump 117 is located within about 30 cm of the processing chamber 113. The recycling line 121 is also configured so as to have a relatively short length (e.g., to reduce recombination of at least one reactive species when the reactive species travels from the pump 117 to the remote plasma source 115 and/or to the processing chamber 113 as described below). Preferably the recycling line 121 has a length of about 100 cm or less. The combination of the pump 117 being adjacent the processing chamber 113 and the use of a relatively short recycling line 121 creates a relatively short path length by which reactive species may leave the processing chamber 113 and return thereto (e.g., reducing the probability that the reactive species will recombine during its return to the processing chamber 113). In at least one embodiment of the invention, the processing chamber 113, the remote plasma chamber 115, the pump 117 and the recycling line 121 may form a modular unit 122 (as shown in phantom) and/or may occupy a small footprint. The modular unit 122 may be mobile (e.g., as represented by wheels 122a-b shown in phantom).

The processing chamber 113 may comprise any suitable processing chamber, such as a deposition chamber, an etch chamber, etc., adapted to perform semiconductor manufacturing processes (e.g., deposition, etching, etc.) on a substrate (not shown). An exemplary deposition chamber is an Applied Materials, Inc. DxZ chamber, and an exemplary etch chamber is an Applied Materials, Inc. MxP chamber.

The remote plasma source 115 may comprise any conventional plasma source such as a microwave discharge plasma source, an inductively coupled plasma source, a silent barrier discharge plasma source, a capacitively coupled plasma source, a toroidal plasma source or any other plasma source capable of dissociating a portion of the process gas supplied to the remote plasma chamber 115 from the process gas source 114. An exemplary remote plasma source is an Astex, Inc. Astron™ toroidal plasma source.

In the exemplary embodiments described herein, the process gas source 114 comprises a source of NF₃, and the process chamber 113 comprises either (1) a deposition chamber that employs reactive species (e.g., F radicals) formed from the NF₃ to etch silicon-containing material layers from surfaces of the deposition chamber (e.g., to clean the chamber surfaces of the deposition chamber); or (2) an etch chamber that employs reactive species formed from the NF₃ to etch silicon-containing material layers formed on a semiconductor substrate (e.g., to pattern the substrate). Specifically, as is known in the art, NF₃ may be dissociated within a plasma chamber (e.g., the remote plasma source 115) so as to form F radicals, and these F radicals may react with silicon-containing material layers (e.g., SiO₂, Si₃N₄, SiC, etc.) to form volatile reactions products (e.g., SiF₄). The volatile reaction products thereafter may be exhausted from a processing chamber via a vacuum pump (e.g., the pump 117), leaving either cleaned chamber surfaces (e.g., if employed to clean a deposition chamber) or an etched substrate (e.g., if employed to etch a substrate). It will be understood that, in general, the present invention may be employed with other processing chambers and other gases (e.g., CF₄, C₂F₆, C₃F₈, CHF₃, SF₆, C₄F₈0, etc.).

During a conventional cleaning/etching process within a chamber, a process gas (e.g., NF₃) and/or reactive species formed from the dissociation of the process gas (e.g., F radicals) are continuously supplied to the chamber (e.g., via a chamber inlet or mass flow controller), and are continuously pumped from the chamber (e.g., via an outlet). A continuous flow of process gas and/or reactive species through the chamber thereby results. When the process gas is a global warming gas such as NF₃, very high plasma powers (e.g., within the remote plasma source 115) are typically employed so as to dissociate approximately all (e.g., 99%) of the NF₃ before the NF₃ enters the chamber. In this manner, little NF₃ will be exhausted from the chamber during cleaning/etching, despite the use of a continuous gas flow. Nonetheless, because only a small portion of the F radicals generated by the dissociation of NF₃ ever reach a chamber/substrate surface and react therewith before being exhausted, the utilization efficiency of F radicals is low (e.g., due to the recombination of atomic F into molecular F₂, despite such high dissociation efficiencies). The large concentration of F₂ molecules exhausted during a conventional cleaning/etching process presents additional concerns as F₂ is a hazardous air pollutant.

The inventive processing system 111 of FIG. 1 overcomes the above shortcomings by "recycling" a portion of the gases pumped from the processing chamber 113 during cleaning or etching while employing a pump 117 adjacent the processing chamber 113 and a recycling line 121 having a relatively short length. For example, during a cleaning process within the processing chamber 113, the process gas source 114 supplies NF₃ to the remote plasma source 115, and the remote plasma source 115 dissociates the NF₃ into F radicals. The F radicals travel from the remote plasma source 115 into the processing chamber 113, and a portion of the F radicals react with chamber surfaces to form volatile reaction products such as SiF₄. The "unreacted" F radicals, any non-dissociated NF₃ and the volatile reaction products are pumped from the processing chamber 113 via the pump 117, along with any F₂ which may form from the recombination of F radicals.

As with conventional cleaning processes, a portion of the gases pumped from the processing chamber 113 may be exhausted via the main exhaust 119. However, unlike conventional cleaning processes, at least a portion of the gases pumped form the processing chamber 113 are recycled via the recycling line 121. Specifically, the recycling line 121 directs a portion of the gases pumped from the processing chamber 113 (e.g., F radicals, F₂, NF₃, etc.) back to the remote plasma source 115 (or directly into the processing chamber 113 as described below), where any recycled NF₃ and F₂ may be dissociated to form additional F radicals. The additional F radicals then may be introduced into the processing chamber 113. The process of recycling at least a portion of the gases pumped from the processing chamber 113 is repeated until the processing chamber 113 has been cleaned to a desired level. In at least one embodiment, the processing chamber 113, the remote plasma source 115, the pump 117 and the recycling line 121 may form a "closed loop" that continuously recycles NF₃, F radicals and F₂ molecules (e.g., and SiF₄, O₂ if SiO₂ is being cleaned, etc.)

The advantages provided by recycling a portion of the gases pumped from the processing chamber 113 are numerous. For example, by recycling exhausted gases, the utilization efficiencies of NF₃ and F are significantly increased as both NF₃ and F radicals may travel multiple times through the processing chamber 113 before being exhausted to the main exhaust 119 (e.g., increasing the likelihood that the NF₃ will be dissociated and that the F radicals will react to form volatile reaction products). Accordingly, less NF₃ is required as F radicals are more efficiently utilized, global warming emissions are reduced as less NF₃ is consumed, and hazardous pollutant emissions are reduced as fewer F radicals are exhausted. Further, because the NF₃ is recycled and not directly exhausted, the remote plasma source 115 may be operated at a lower power because the NF₃ may travel multiple times through the remote plasma source 115, and need not dissociate during its first pass through the remote plasma source 115.

While recycling NF₃, F radicals and/or F₂ may have numerous advantages, the recycling of reaction products may be less desirable. For example, if SiF₄ is "recycled" so as that it enters the remote plasma source 115 from the recycling line 121, the SiF₄ may dissociate within the remote plasma source 115 and deposit Si on the interior surfaces of the remote plasma source 115 and/or the processing chamber 113 (e.g., damaging the remote plasma source 115 and/or defeating the purpose of cleaning the processing chamber 113). Referring again to FIG. 1, to reduce the recycling of volatile reaction products (e.g., SiF4) and other contaminants (while allowing the recycled NF₃, F radicals and/or F₂), the processing chamber 113 may employ any known method for removing reaction products and/or contaminants from a gas stream. For example, the pump 117 and/or the recycling line 121 may employ an ultrasonic module (e.g., the ultrasonic module 123 in FIG. 1) that employs an ultrasonic technique to separate species (e.g., to separate Si from SiF₄) based on weight and/or molecular symmetry as is known the art. Alternatively (or additionally), a particle filtering device (e.g., a filter 125 in FIG. 1) such as a conventional mechanical filter, a conventional membrane, a conventional electrostatic trapping device, a magnetic type separation quadrupole device, a mass separation device, a turbomolecular pump employing inertia, etc., may be employed within the pump 117 and/or the recycling line 121 to prevent the recycling of reaction products and/or contaminants through the remote plasma source 115 and/or the processing chamber 113. Such particle filtering devices preferably are resistant to attack by the process gas, reactive species and reaction products of the underlying cleaning/etching process. Other techniques and/or apparatus may be employed within the pump 117 and/or the recycling line 121 to prevent the recycling of reaction products and/or contaminants through the remote plasma source 115 and/or the processing chamber 113.

To improve the efficiency of the above-described recycling process, many variations of the above-described process and of the processing chamber 113 may be employed. For example, because of the introduction of F₂, F radicals, reaction products/contaminants and other "recycled" gases into the remote plasma source 115 (from the pump 117), the composition/impedance of the plasma within the remote plasma source 115 may change. Therefore, it may be desirable to (1) re-direct a portion of the recycled gases directly into the processing chamber 113 (e.g., by bypassing the remote plasma source 115 via a path 129 shown in phantom in FIG. 1, so as to reduce the affect the recycled gases have on the plasma within the remote plasma source 115); (2) introduce additional NF₃ from the process gas source 114 along with the recycled exhaust gases (e.g., to "dilute" the affect the recycled gases have on the plasma within the remote plasma source 115; and/or (3) adjust the power applied to the plasma to compensate for any affects that the recycled gases have on the plasma (e.g., by changing the power matching system of the remote plasma source 115, by employing an alternate power source (not shown), etc.).

In certain circumstances, it may be possible to eliminate the remote plasma source 115, or to employ the remote plasma source 115 only a portion of the time (e.g., by passing the recycled gases through the remote plasma source 115 only a portion of the time). For example, by placing the pump 117 adjacent the processing chamber 113 and by employing a relatively short recycling line 121 in accordance with the invention, F radicals pumped from the processing chamber 113 in some instances may be re-introduced to the processing chamber 113 via the recycling line 121 and the path 129 before the F radicals recombine to form F₂ (e.g., a more stable species that is not efficient at etching silicon containing materials). Accordingly, in such instances, the remote plasma source 115 may not be required if a sufficient number of F radicals can be recycled before recombining.

To further decrease the probability of F radical recombination, the NF₃ introduced by the process gas source 114 may be diluted with N, Ar, He or some other non-reactive gas (e.g., to spatially separate F radicals and prevent their recombination). Alternatively, the NF₃ may be diluted with a vibrationally excited non-reactive gas (e.g., N, Ar, He) that may release energy downstream from the process gas source 114 (e.g., within the processing chamber 113, the pump 117 or the recycling line 121) to break apart F₂ molecules or to keep F₂ molecules from forming. A separate plasma source (e.g., other than the remote plasma source 115) also may be employed to selectively ionize recycled NF₃ and/or F₂, while not ionizing SiF₄ and other reaction products. For example, a plasma source within the processing chamber 113 (not shown) may be employed to selectively ionize recycled NF₃ and/or F₂ through proper selection of plasma power. If desired, a non-plasma ionization mechanism or some other reactive species generator such as an ultraviolet radiation source, or some other emission line source may be employed to selectively ionize recycled NF₃ and/or F₂, but not SiF₄. Note that, in general, because a lower power level may be employed to dissociate NF₃ from the process gas source 114 (e.g., because the NF₃ is recycled and need not be dissociated with a 99% efficiency to achieve low global warming gas emissions), a process chamber's plasma source may be employed to dissociate NF₃ in place of the remote plasma source 115.

A controller 131 (e.g., one or more conventional microprocessors or microcontrollers) may be coupled to one or more of the source of process gas 114, the remote plasma source 115, the pump 117, the main exhaust 119, the recycling line 121 (e.g., by coupling the controller 131 to a throttle valve not shown), the ultrasonic module 123 and/or the filter 125, and may contain computer program code for directing the processing system 111 in accordance with the present invention (e.g., to recycle at least a portion of the gases that are pumped from the processing chamber 113 during cleaning or etching, to control the amount of gas that is recycled, to control the operation of the processing chamber 113 during cleaning or etching, to control the operation of the ultrasonic module 123 and/or of the filter 125, etc.).

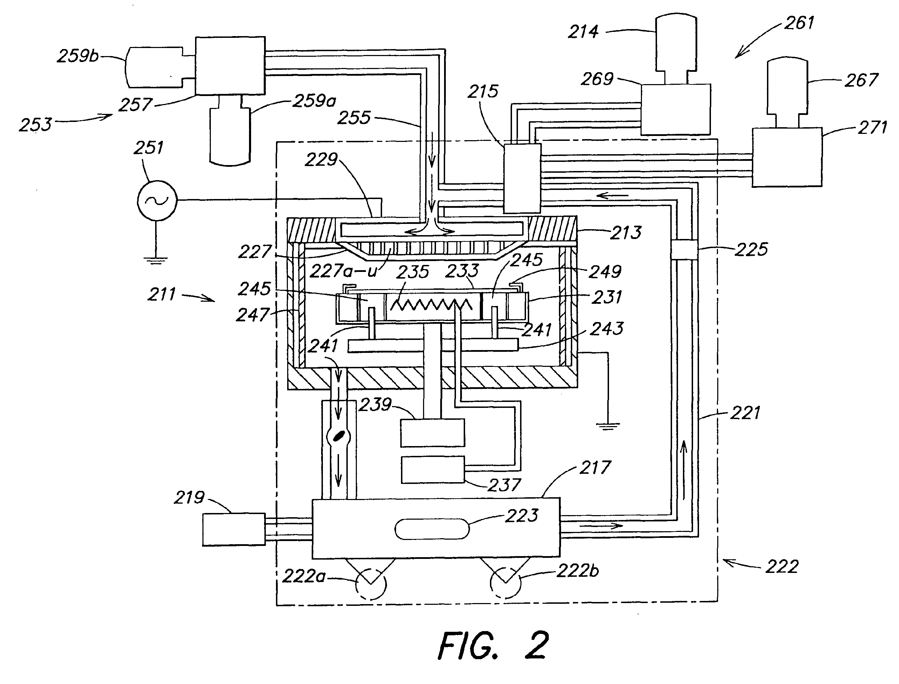

FIG. 2 is a diagrammatic side view of an inventive processing system 211 that represents an exemplary embodiment for the inventive processing system 111 of FIG. 1. With reference to FIG. 2, the inventive processing system 211 comprises a deposition chamber 213 coupled to a source of precursor gas 214 (e.g., a source of NF₃) via a remote plasma source 215, and coupled to a pump 217 (e.g., a mechanical pump, a turbo-molecular pump, etc.). The pump 217 is coupled to a main exhaust 219 (e.g., an exhaust used by a plurality of processing chambers such as a main exhaust of a clean room), and a recycling line 221 is coupled between the pump 217 and the remote plasma source 215. The pump 217 is positioned adjacent the deposition chamber 213 to reduce recombination of at least one reactive species (e.g., F) when the reactive species travels from the processing chamber to the pump 217, and the recycling line 221 is also configured so as to have a relatively short length (e.g., to reduce recombination of at least one reactive species when the reactive species travels from the pump 217 to the remote plasma source 215 and/or to the deposition chamber 213 as described below). The pump 217 and/or the recycling line 121 may employ an ultrasonic module 223 and/or a particle filtering device 225 to reduce the recycling of reaction products/contaminants as previously described. A throttle valve (not shown) may be employed between the pump 217 and the particle filtering device 225 to tailor the amount of gas pumped from the chamber 213 that is recycled thereto.

In at least one embodiment of the invention, the deposition chamber 213, the remote plasma chamber 215, the pump 217 and the recycling line 221 may form a modular unit 222 (as shown in phantom). Additionally, the pump 217 and/or the recycling line 221 may be positioned above or below the deposition chamber 213 so that the footprint of the system is minimal. The modular unit 222 may be mobile (e.g., as represented by wheels 222a-b shown in phantom).

Exemplary processing systems on which the inventive processing system 211 may be based include an DxZ chamber manufactured by Applied Materials, Inc., a model AKT-1600 PECVD System manufactured by Applied Kamatsu Technology and described in US-A-5,788,778, and the GIGAFILL™ processing system manufactured by Applied Materials, Inc. and described in US-A-5,812,403.

The deposition chamber 213 comprises a gas distribution plate 227 with apertures 227a-u and a backing plate 229 for delivering processing gases and cleaning gases into the deposition chamber 213, and a susceptor 231 for supporting a substrate 233 to be processed within the deposition chamber 213. The susceptor 231 includes a heater element 235 (e.g., a resistive heater) coupled to a heater control 237 for elevating the temperature of the substrate 233 to a processing temperature and for maintaining the substrate 233 at the processing temperature during processing.

A lift mechanism 239 is coupled to the susceptor 231 to allow the substrate 233 to be lifted from the susceptor 231, as described below. Specifically, a plurality of lift pins 241 (fixedly held by a lift pin holder 243) penetrate the susceptor 231 (through a plurality of lift pin apertures 245) so as to contact and lift the substrate 233 from the susceptor 231 when the susceptor 231 is lowered by the lift mechanism 239. The deposition chamber 213 further comprises a chamber wall liner 247 which blocks material from accumulating on the chamber wall and which can be removed and cleaned, and a shadow frame 249 which overhangs the substrate 233's edge and thereby prevents material from depositing or accumulating on the substrate 233's edge.

In addition to their above described functions, the gas distribution plate 227 and the susceptor 231 also serve as parallel plate upper and lower electrodes, respectively, for generating a plasma within the deposition chamber 213. For example, the susceptor 231 may be grounded and the gas distribution plate 227 coupled to an RF generator 251. An RF plasma thereby may be generated between the gas distribution plate 227 and the susceptor 231 through application of RF power supplied thereto by the RF generator 251.

The processing system 211 further comprises a first gas supply system 253 coupled to an inlet 255 of the deposition chamber 213 for supplying processing gases thereto through the backing plate 229 and the gas distribution plate 227. The first gas supply system 253 comprises a valve controller system 257 (e.g., computer controlled mass flow controllers, flow meters, etc.) coupled to the inlet 255 of the deposition chamber 213, and a plurality of process gas sources 259a, 259b coupled to the valve controller system 257. The valve controller system 257 regulates the flow of processing gases to the deposition chamber 213. The specific processing gases employed depend on the materials being deposited within the deposition chamber 213.

In addition to the first gas supply system 253, the processing system 211 comprises a second gas supply system 261 coupled to the inlet 255 of the deposition chamber 213 (via the remote plasma source 215) for supplying cleaning gases thereto during cleaning of the deposition chamber 213 (e.g., to remove accumulated material from the various interior surfaces of the chamber 213). The second gas supply system 261 comprises the precursor gas source 214 and a carrier gas source 267 coupled to the remote plasma source 215 via a valve controller system 269 and a valve controller system 271, respectively. Typical precursor cleaning gases include NF₃, CF₄, SF₆, C₂F₆, CCl₄, C₂Cl₆, etc., as are well known in the art. The carrier gas, if employed, may comprise any gas compatible with the cleaning process being employed (e.g., argon, helium, hydrogen, nitrogen, oxygen, etc.). The precursor and carrier gas sources 214, 267 may comprise a single gas source if desired, containing an appropriate mixture of the precursor and carrier gases.

In operation, during cleaning of the deposition chamber 213 to remove a material (e.g., Si) from the surfaces thereof, a precursor gas (e.g., NF₃) is delivered to the remote plasma source 215 from the precursor gas source 214. The flow rate of the precursor gas is set by the valve controller system 269. The remote plasma source 215 activates a portion of the precursor gas to form one or more reactive species (e.g., dissociates the NF₃ to form fluorine radicals) which travel to the deposition chamber 213 through the gas conductance line 263. The remote plasma source 215 thus serves as a "reactive species generator" that is coupled to the deposition chamber 213 and delivers reactive species thereto. Note that the susceptor 231 and the gas distribution plate 227 also may serve as a reactive species generator coupled to the deposition chamber 213 as the RF power applied therebetween may dissociate the precursor gas.

The one or more reactive species generated by the remote plasma source 215 travel through the inlet 255, through the backing plate 229, through the gas distribution plate 227 and into the deposition chamber 213. A carrier gas may be supplied to the remote plasma source 215 from the carrier gas source 267 to aid in transport of the one or more reactive species to the chamber 213 and/or to assist in chamber cleaning or plasma initiation/stabilization within the deposition chamber 213 if an RF plasma is employed during chamber cleaning.

The carrier gas supplied by the carrier gas source 267 may also serve to dilute the reactive species generated by the remote plasma source 215, and may comprise a vibrationally excited non-reactive gas that may release energy downstream from the reactive plasma source 215 (e.g., within the deposition chamber 213, the pump 217 or the recycling line 221) to break apart reactive species that have recombined (e.g., F₂ molecules) or to keep reactive species from recombining.

Once the reactive species formed within the remote plasma source 215 enter the deposition chamber 215, a portion of the reactive species react with chamber surfaces to form volatile reaction products (e.g., SiF₄ if NF₃ is the precursor gas). The "unreacted" reactive species (e.g., unreacted F radicals), any non-dissociated precursor gas and the volatile reaction products are pumped from the deposition chamber 213 via the pump 217, along with any byproducts from the recombination of reactive species (e.g., F₂ formed from F radicals).

As with conventional cleaning processes, a portion of the gases pumped from the deposition chamber 213 may be exhausted via the main exhaust 219. However, unlike conventional cleaning processes, at least a portion of the gases pumped form the deposition chamber 213 are recycled via the recycling line 221. Specifically, the recycling line 221 directs a portion of the gases pumped from the deposition chamber 213 (e.g., reactive species such as F radicals, recombined reactive species such as F₂, precursor gas such as NF₃, etc.) back to the remote plasma source 215 (or directly into the deposition chamber 213 as described previously with reference to FIG. 1), where any recycled precursor gas (e.g., NF₃) and recombined reactive species (e.g., F₂) may be dissociated to form additional reactive species (e.g., F radicals). The additional reactive species then may be introduced into the deposition chamber 213. The process of recycling at least a portion of the gases pumped from the deposition chamber 213 is repeated until the deposition chamber 213 has been cleaned to a desired level. The processing chamber 113, the remote plasma source 215, the pump 217 and the recycling line 221 may form a "closed loop" that continuously recycles gases.

As stated, the advantages provided by recycling a portion of the gases pumped from a processing chamber such as the deposition chamber 213 are numerous. For example, by recycling exhausted gases, the utilization efficiencies of precursor gases and reactive species are significantly increased as both may travel multiple times through the processing chamber before being exhausted (e.g., increasing the likelihood that the precursor gas will be dissociated and that the reactive species will react to form volatile reaction products). Accordingly, less precursor gas is required and fewer pollutants are exhausted. Further, because the precursor gas (e.g., NF₃) is recycled and not directly exhausted, remote plasma sources may be operated at a lower power (e.g., because the precursor gas may travel multiple times through the remote plasma source, and need not dissociate during its first pass through the remote plasma source). TABLE 1 lists a comparison between the precursor gas flow rates, power levels and hazardous air pollutants emitted for a conventional NF₃ cleaning process and the predicted precursor gas flow rates, power levels and hazardous air pollutants emitted for an NF₃ cleaning process that employs the inventive configuration of FIG. 2 (e.g., a pump 217 adjacent to the deposition chamber 213 and a short length recycling line 221 that both reduce recombination of reactive species). As shown in TABLE 1, it is predicted that through use of the inventive processing system 211 of FIG. 2, NF₃ consumption will be reduced by a factor of between 2-4, remote plasma power levels will be reduced by a factor of about 3, and the emission of hazard air pollutants (e.g., F₂) will be reduced by about a factor of 10 or more.

**TABLE 1**

| CONVENTIONAL NF₃ CLEANING PARAMETERS | PREDICTED NF₃ CLEANING PARAMETERS FOR PROCESSING SYSTEM 211 |
|---|---|
| 2 liters NF₃/min during cleaning process | 0.5-1 liters NF₃/min during cleaning process |
| 5 kW remote plasma source power | 1.5 kW remote plasma source power |
| emission of 2-2.5 liters of F₂ during cleaning | emission of 0.2-0.25 liters of F₂ during cleaning |

The foregoing description discloses only the preferred embodiments of the invention, modifications of the above disclosed apparatus and methods which fall within the scope of the invention will be readily apparent to those of ordinary skill in the art. For instance, while the present invention has been described primarily with reference to etching and cleaning processes, it will be understood that the invention has applicability to other processes (e.g., non-semiconductor processes).

## Claims

1. A processing system comprising:
a processing chamber;
a source of gas coupled to the processing chamber and adapted to supply a gas to the processing chamber;
a pump located adjacent the processing chamber, coupled to the processing chamber, and adapted to pump the gas from the processing chamber; and
a recycling line, coupled to the pump and adapted to cycle at least a portion of the gas pumped from the processing chamber back into the processing chamber.

2. The processing system of claim 1 wherein the processing chamber comprises an etch chamber or a deposition chamber.

3. The processing system of claim 2 further comprising a remote plasma source coupled between the source of gas and the processing chamber, the remote plasma source adapted to dissociate at least a portion of the gas before the gas enters the processing chamber.

4. The processing system of claim 2 wherein the processing chamber comprises a reactive species generator adapted to dissociate the gas.

5. The processing system of claim 4 wherein the reactive species generator comprises a plasma source.

6. The processing system of claim 2 wherein the processing chamber, the pump, and the recycling line are positioned so as not to increase a footprint of the processing system.

7. The processing system of claim 2 wherein at least one of the recycling line and the pump comprises a filter adapted to remove at least one of a reaction product and contaminants pumped from the processing chamber with the gas.

8. The processing system of claim 2 wherein the at least one of the recycling line and the pump comprises an ultra-sonic module adapted to separate at least one of a reaction product and contaminants pumped from the processing chamber with the gas.

9. A method of cleaning a deposition chamber, the method comprising:
providing a processing chamber adapted to perform a process by which material accumulates on at least one chamber component;
cleaning the processing chamber with a reactive species which removes accumulated material from the at least one chamber component;
pumping the reactive species from the processing chamber with a pump positioned adjacent the processing chamber; and
cycling at least a portion of the reactive species pumped from the processing chamber back into the processing chamber.

10. A method of etching a substrate, the method comprising:
providing a processing chamber adapted to perform a process by which material is removed from a substrate;
positioning a substrate within the processing chamber;
etching the substrate with a reactive species which removes the material from the substrate;
pumping the reactive species from the processing chamber with a pump positioned adjacent the processing chamber; and
cycling at least a portion of the reactive species pumped from the processing chamber back into the processing chamber.

11. The method of claim 9 or 10 further comprising generating the reactive species by dissociating a portion of a processing gas.
